# EUROPÄISCHE PATENTSCHRIFT

(11) **EP 1 249 043 B1**
(45) Veröffentlichungstag und Bekanntmachung des Hinweises auf die Patenterteilung: **03.03.2010**
(21) Anmeldenummer: 00988589.8
(22) Anmeldetag: 13.11.2000
(51) Int. Cl.: H01L 27/06, H03G 11/02

(54) **INTEGRIERTER LIMITER UND VERFAHREN ZUR HERSTELLUNG EINES INTEGRIERTEN LIMITERS**
INTEGRATED LIMITER AND METHOD FOR PRODUCING AN INTEGRATED LIMITER
LIMITEUR INTEGRE ET SON PROCEDE DE PRODUCTION

(30) Priorität: 26.11.1999 DE 19956904
(43) Veröffentlichungstag der Anmeldung: 16.10.2002
(73) Patentinhaber: United Monolithic Semiconductors GmbH, 89081 Ulm (DE)
(72) Erfinder: BEHAMMER, Dag, 89079 Ulm (DE)
(74) Vertreter: Weber, Gerhard
(86) Internationale Anmeldenummer: PCT/DE2000/003967
(87) Internationale Veröffentlichungsnummer: WO 2001/039270

(56) Entgegenhaltungen:
- DE-A- 19 543 540
- DE-A- 19 543 540
- DE-A- 19 547 284
- DE-A- 19 650 821
- DE-A- 19 726 070
- DE-A- 19 730 322
- JP-A- 09 270 445
- JP-A- 09 306 991
- JP-A- 10 135 408
- JP-A- 10 161 158
- JP-A- 10 258 475
- US-A- 5 341 114
- US-A- 5 343 070

## Beschreibung

Die Erfindung bezieht sich auf ein Verfahren nach dem Patentanspruch 1 sowie auf eine Anordnung nach dem Patentanspruch 8.

Die Erfindung betrifft monolithisch integrierte Schaltkreise für Mikrowellen und Millimeterwellen (MMICs) und insbesondere den Schutz von empfindlichen Empfangsverstärkern (LNA) in Sende-Empfangsmodulen, sogenannte T/R-Module, gegen zu große HF-Eingangsleistung, Spikes oder elektromagnetische Pulse.

Aus dem Stand der Technik ist es bekannt, Begrenzer mit hoher Verlustleistung zu verwenden, die aus Silizium-PIN-Dioden aufgebaut sind, um rauscharme Empfangsverstärker zu schützen, die in den Frequenzbereichen der Mikrowellen und den Millimeterwellen arbeiten. Ein Nachteil der PIN-Dioden besteht bisher darin, daß sie nicht monolithisch integrierbar sind. Dies wiederum erfordert die Herstellung diskreter Bauelemente, die später in eine Schaltung eingebaut werden und hinsichtlich der verschiedenen Widerstands-, Kapazitäts-, Induktivitäts- und der parasitären Werte rauschangepaßt werden müssen.

Eine PIN-Diode von Mesa-Typ und eine monolithisch integrierte Schaltungsanordnung mit einer solchen PIN-Diode, einem Widerstand und einem Kondensator in verschiedenen Ebenen eines Schichtaufbaus auf einem Substrat sind z.B. aus der US-A-5,343,070 bekannt.

Prinzipiell können derartige Amplitudenbegrenzer in drei verschiedenen Betriebsmoden eingesetzt werden:
- Der Durchgangsmode beim Empfang schwacher Signale
- Der Begrenzungsmode beim Empfang von Signalen hoher Leistung
- Der Sperrmode, der von außen durch ein Steuersignal wählbar ist, zum Trennen eines Empfangsverstärkers von der Antenne.

Wichtig ist bei einem absorbierenden Amplitudenbegrenzer, daß im Begrenzungs- und im Sperrmode das empfangene Signal im Begrenzer absorbiert wird und nicht zum Eingang der Schaltung zurück reflektiert wird. Es sind zwei Möglichkeiten denkbar, einen derartigen absorbierenden Begrenzer zu realisieren. Grundlage für beide Fälle ist ein sogenannter reflektierender Amplitudenbegrenzer, der aus λ/4-Leitungen und vorzugsweise aus zwei PIN-Dioden besteht. Die beiden PIN-Dioden sind eingangs- und ausgangsseitig jeweils gegen ein Bezugspotential geschaltet.

Aus der Schrift DE 197 26 070 bekannt ist ein absorbierender Amplitudenbegrenzer für HF-Signale mit einem reflektierenden Begrenzer, der insbesondere durch eine λ/4-Leitung und eine eingangsseitig und eine ausgangsseitig, jeweils gegen ein Bezugspotential geschaltete Diode realisiert ist. Die Absorptionsschaltung weist einen Lastwiderstand auf sowie eine dem Begrenzer vorgeschaltete weitere λ/4-Leiturig. Eingangsseitig besteht diese aus einer weiteren Diode und dem Lastwiderstand in Reihe geschaltet und ist mit dem Bezugspotential verbunden. Parallel zum Lastwiderstand ist eine HF-Sperre geschaltet. Zudem kann der Amplitudenbegrenzer über eine Steuerung verfügen, die über eine zusätzliche HF-Sperre mit dem reflektierenden Begrenzer verbunden ist, so daß der Amplitudenbegrenzer zwischen einem Durchgangs- und einem Sperrmode umschaltbar ist.

In der DE 41 36 092 A1 ist ein in eine Schaltung für Mikrowellen und Millimeterwellen integrierter Begrenzer zu entnehmen, der antiparallel geschaltete Schottky-Dioden enthält, um günstige leakage- und gute Flat leakage-Werte zu erhalten. Eine Diodensperrschicht ist durch die Sperrschicht eines nachfolgenden Feldeffekttransistors gebildet. Die Schottky-Dioden liegen im Querzweig eines Tiefpasses zur Rauschanpassung für den nachfolgenden Feldeffekttransistor. Sämtliche Teile sind auf einem Substrat monolithisch integriert.
Das Verfahren zu dessen Herstellung beinhaltet ein halbisolierendes Substrat, bei dem diesem eine oder mehrere Halbleiterschichten epitaktisch aufgewachsen und eine oder mehrere Halbleiterschichten zu einer Mesa geätzt werden. Ein erster Satz Metallschichten werden auf dem Substrat einschließlich des Mesas abgelagert, um Schottky-Kontakte mit einer der darunter befindlichen Halbleiterschichten herzustellen. Auf der Mesa werden für die Schottky-Dioden Bereiche festgelegt und der erste Satz Metallschichten geätzt, so daß eine Metallisierung zurückbleibt, die die Schottky-Kontakte in diesen Bereichen erzeugt. Eine oder mehrere isolierende Schichten werden auf dem Substrat einschließlich des Mesas und der Schottky-Kontakte abgelagert und ein erster Satz von Löchern in die isolierenden Schichten geätzt, um die Halbleiterschichten auf der Mesa freizulegen. Ein zweiter Satz aus Metallschichten wird in dem ersten Satz von Löchern abgelagert, um ohmsche Kontakte mit den Halbleiterschichten herzustellen. Ein zweiter Satz von Löchern wird in die isolierenden Schichten geätzt, um die Schottky-Kontakte freizulegen und eine Serie von Metallschichten und Oxiden auf dem Substrat einschließlich des Mesas und der ersten und zweiten Sätze von Löchern abzulagern. Die Serie von Schichten wird geätzt, um durch eine zwischen den Metallschichten der Serie befindliche Oxidschicht zu erzeugen und um durch eine Metallschicht der Serie eine Induktivität herzustellen sowie um Leiter zu erzeugen, die die ohmschen Kontakte und die Schottky-Kontakte miteinander verbinden, derart, daß die Schottky-Dioden eine antiparallele Gruppe aus auf dem Substrat monolithisch integrierten Schottky-Dioden bilden. Eine erste und eine zweite Schottky-Diode liegt parallel und mit einander entgegengesetzer Polarität zwischen einem ersten Eingangsknoten und einem Eingangsknoten, wobei einer der Leiter der Serie ein erstes Ende bildet, das einen Begrenzerausgang zum Anschluß des rauscharmen Verstärkers darstellt, wobei der erste Eingangsknoten an den Leiter zwischen dessen ersten und dessen zweiten Ende angekoppelt ist und wobei der erste Ausgangsknoten an eine Bezugsmasse angekoppelt ist.

Ein weiterer integrierter Limiter mit einer Anordnung von antiparallel geschaltenen Schottky-Dioden ist aus der US 5,341,114 bekannt.

Der Erfindung liegt die Aufgabe zugrunde, ein verbessertes Verfahren zur Herstellung und eine Anordnung eines integrierten Limiters anzugeben.

Die Erfindung wird in Bezug auf das Verfahren durch die Merkmale des Patentanspruchs 1 und in Bezug auf die Anordnung durch die Merkmale des Patentanspruchs 8 wiedergegeben. Die weiteren Ansprüche enthalten vorteilhafte Aus- und Weiterbildungen der Erfindung.

Die Erfindung beinhaltet ein Verfahren zur Herstellung eines integrierten Limiters mit PIN-Dioden, wobei auf einem hochleitenden n⁺-Substrat eine Schichtenfolge einer Diodenstruktur abgeschieden wird. Mittels einer Mesastruktur, die bis ins n⁺-Substrat reicht, wird dabei zumindest eine Diode erzeugt. Die Diode wird durch Leiterbahnen elektrisch angeschlossen und die Oberfläche mit einer ersten Planarisierung abgedeckt. Auf dieser ersten Planarisierung wird zumindest ein ohmscher Widerstand strukturiert und eine erste BCB(Benzocyclobuten)-Isolationsschicht abgeschieden, durch die Diode und Widerstand mittels Leiterbahnen verschaltet werden. Eine zweite Planarisierung wird mit einer zweiten BCB-Isolationsschicht hergestellt. Auf der zweiten Planarisierung wird zumindest ein Kondensator gebildet, der ebenfalls mittels Leiterbahnen mit Diode und Widerstand über Kontaktlöcher verschaltet wird. Eine dritte Planarisierung wird mit einer dritten BCB-Isolationsschicht strukturiert und durch Kontaktlöcher in der dritten Planarisierung die Struktur mittels Leiterbahnen verbunden und durch eine Anschlußmetallisierung kontaktiert. Die Dicken der BCB-Schichten sind so gewählt, daß zwischen dem Substrat und der obersten Metallisierung eine möglichst verlustarme TFM (Thin Film Microstripe)-Leitung gebildet wird.

Zu einem verbesserten ohmschen Kontakt führt eine hochleitende n⁺⁺- Kontaktimplantation im n⁺-Substrat, wobei auf der Mesastruktur dann eine zusätzliche erste Oxidschicht als Schutz aufgebracht ist.
Zur Passivierung der Seitenflanken der Mesastruktur wird ein Seitenwandspacer aus siliziumreichen Siliziumoxid oder Siliziumnitrid gebildet.
Auf der p-Siliziumschicht der Mesa und der Substratoberfläche wird eine zusätzliche Salizidschicht gebildet.

Der integrierte Limiter mit PIN-Dioden hat folgenden Aufbau:
- Auf einem hochleitenden n⁺-Substrat ist in einer ersten Ebene zumindest eine PIN-Diode angeordnet,
- in einer zweiten Ebene ist zumindest ein Widerstand angeordnet,
- in einer dritten Ebene ist zumindest ein Kondensator angeordnet
- auf die dritte Ebene folgt eine Anschlußmetallisierung und
- die Ebenen sind zu einem integrierten Limiter verschaltet.

Ein besonderer Vorteil der Erfindung besteht in der verbesserten Integrationsfähigkeit, wodurch eine kostengünstige Realisierung derartiger Limiter resultiert.
Zudem werden bei der Herstellung bevorzugt Niedertemperaturverfahren angewandt, mit denen das gesamte Temperaturbudget vorteilhafterweise niedrig gehalten wird.

Im folgenden wird die Erfindung anhand von vorteilhaften Ausführungsbeispielen unter Bezugnahme auf schematische Zeichnungen in den Figuren näher erläutert. Es zeigen:
- Fig. 1 a-f: Herstellungsverfahren des Limiters bis zur ersten Planarisierungsebene,
- Fig. 2 a-c: Herstellungsverfahren des Limiters bis zur zweiten Planarisierungsebene,
- Fig. 3 a-b: Herstellungsverfahren des Limiters bis zur dritten Planarisierungsebene mit elektrischem Kontakt.

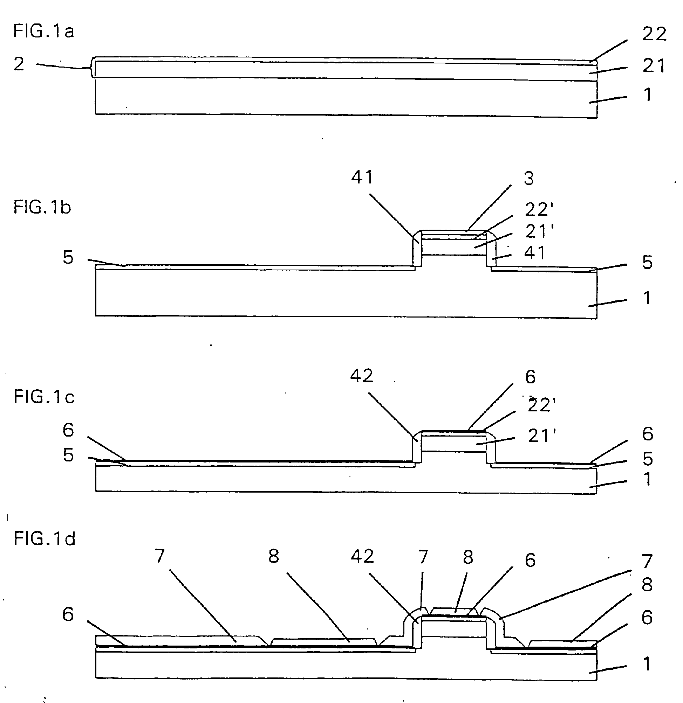

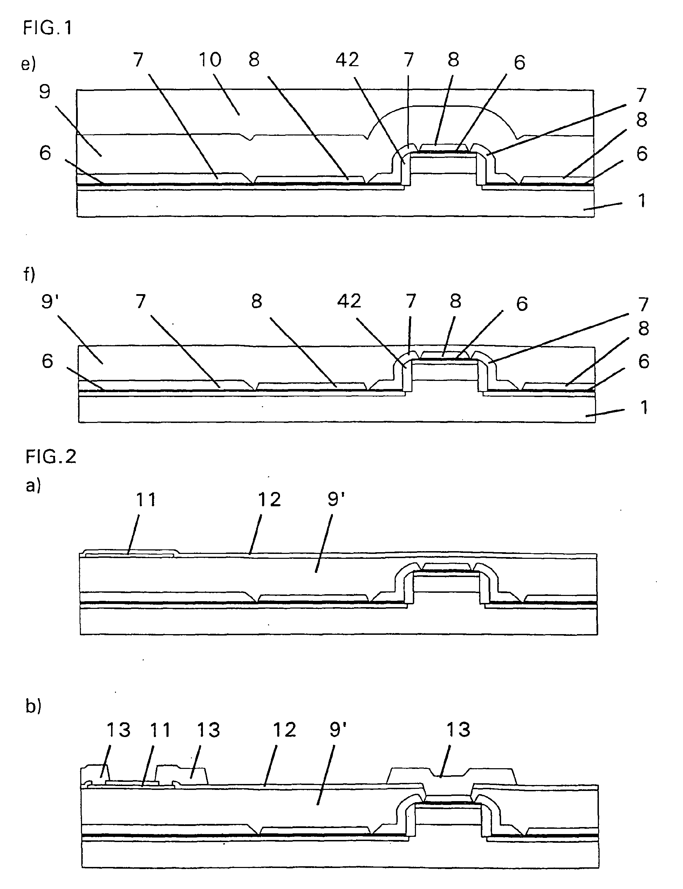

In einem Ausführungsbeispiel gemäß Fig. 1 wird das Verfahren zur Herstellung eines integrierten Limiters mit PIN-Dioden bis zur ersten Planarisierungsebene dargestellt. Auf einem hochleitenden n⁺-Substrat 1 wird eine Schichtenfolge einer Diodenstruktur 2 in Form einer i-Silizium 21 und p⁺-Silizium 22 Schicht ganzflächig abgeschieden (Fig. 1 a).

Mit einer etwa 300 nm dicken ersten Oxidschicht 3 werden die Bereiche für die Dioden abgedeckt. Um diese Bereiche werden die Schichten 21 und 22 bis zum n⁺-Substrat abgeätzt, wobei die Diode als Mesa 21', 22', 3 erzeugt wird. Zum Schutz der Seitenflanken der Mesastruktur werden etwa 200 nm breite Seitenwandspacer 41 aus siliziumreichen Siliziumoxid oder Siliziumnitrid gebildet. Zu einem verbesserten ohmschen Kontakt führt eine hochleitende n⁺⁺- Kontaktimplantation 5 im n⁺-Substrat, wobei auf der Mesastruktur immer noch die erste Oxidschicht 3 als Schutz dient (Fig. 1 b).

Nach Abätzen der Oxidschichten 3 und 41 erfolgt eine kurze thermische Oxidation (RTO) zur Passivierung der Siliziumoberflächen. An den Seitenflanken der Mesastruktur werden wiederum 200 nm breite Seitenwandspacer 42 aus siliziumreichen Siliziumoxid oder Siliziumnitrid gebildet. Nach Reinigung und HF-dip wird ganzflächig Nickel oder Kobalt aufgebracht und in den Bereichen, an denen das Kobalt mit Silizium in Kontakt steht, mit einer Temperaturbehandlung in Inertgasatmosphäre in Silizid (Salizid) 6 umgewandelt. Die auf den Seitenwandspacern 42 verbleibenden Kobaltreste werden mit einem Ätzprozeß abgetragen (Fig. 1c).

Über eine zweite Oxidschicht 7 einer Dicke von etwa 400 nm werden die Bereiche für die nachfolgende elektrische Kontaktierung der Diode festgelegt. Der elektrische Kontakt wird über eine erste Metallisierung 8, beispielsweise bestehend aus einer Schichtenfolge aus Al/Ti, mit einer Dicke von ca. 300 nm mittels lift-off Technik geschaffen (Fig. 1d). Dabei dient die Fotolackstruktur zur Definition der Kontaktlöcher gleichzeitig als lift-off Maske.
Die gesamte Struktur wird dann mit einer etwa 2 µm dicken dritten Oxidschicht 9 ganzflächig abgedeckt (Fig. 1e).
Darüber wird eine Polyimidschicht 10 aufgebracht und eine Planarisierung der dritten Oxidschicht 9 bis etwa auf das Niveau der Diodenmesa durchgeführt. Das Resultat ist eine vollständig planare Restschicht 9' der dritten Oxidschicht 9, die die Diode und die Leiterbahnen abdeckt (Fig. 1f).

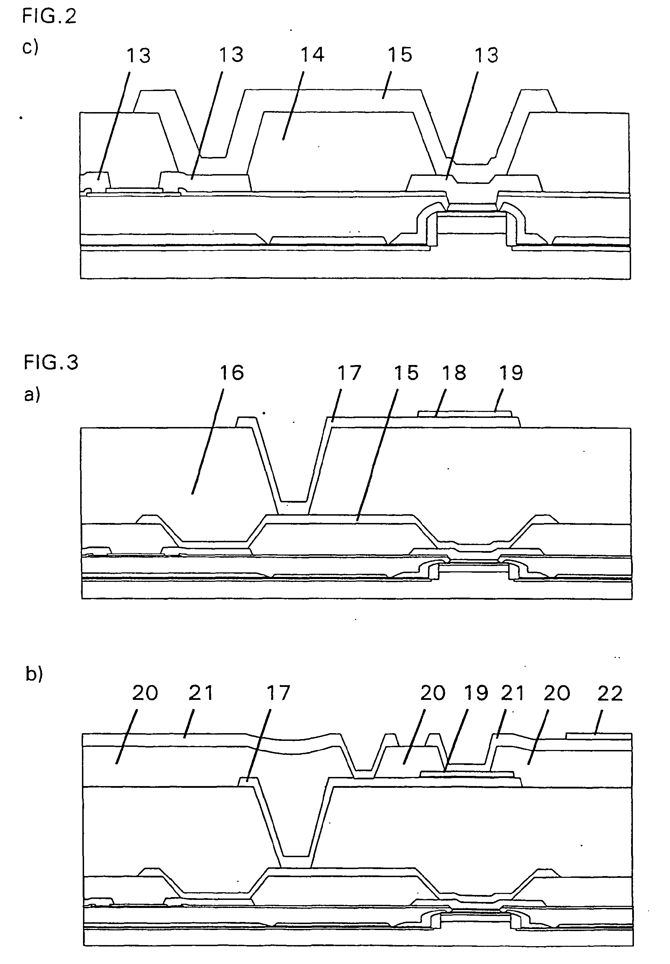

Auf dieser ersten Planarisierung wird zumindest ein ohmscher Widerstand 11, beispielsweise ein aus einem PVD-Prozeß abgeschiedenes WSiₓ strukturiert und mit einer als Isolationsschicht dienenden vierten Oxidschicht 12 einer Dicke von etwa 200 nm abgedeckt (Fig. 2a).
Durch Öffnung der Isolation wird die Diodenebene und der Widerstand mit einer zweiten Metallisierung 13 aus PVD Al/WTi elektrisch angeschlossen (Fig. 2b).
Über eine erste BCB-Isolationsschicht 14 einer Dicke von etwa 8 µm werden Diode und Widerstand mittels Leiterbahnen 15 verschaltet, die aus einer dritten und etwa 4 µm dicken PVD Al/WTi-Metallisierung gebildet werden (Fig. 2c).

Eine zweite Planarisierung 16 wird mit einer zweiten BCB-Isolationsschicht einer Dicke von etwa 34 µm hergestellt. Der elektrische Anschluß mit den darunter befindlichen Ebenen wird mit Leiterbahnen 17, gebildet aus einer vierten Al/WTi-Metallisierung gewährleistet. Auf der zweiten Planarisierung 16 wird zumindest ein Kondensator mittels eines Dielektrikums 18 gebildet und ein elektrischer Kontakt 19 mit einer vierten Metallisierung hergestellt, der mit den strukturierten Leiterbahnen mit Diode und Widerstand über Kontaktlöcher verschaltet wird (Fig. 3a).

Eine dritte Planarisierung wird mit einer dritten BCB-Isolationsschicht 20 einer Dicke von ca. 8 µm strukturiert. Durch Kontaktlöcher in der dritten Planarisierung wird die Struktur mittels Leiterbahnen 21 verschaltet und durch eine Anschlußmetallisierung 22 beispielsweise aus WTi/Au kontaktiert (Fig. 3b).

Der integrierte Limiter enthält PIN-Dioden, Widerstände und Kapazitäten in einer Mehrlagenmetallisierung. Die oberste Leitung auf insgesamt ca. 50 µm BCB als Dielektrikum bildet mit dem n⁺-Substrat (Masse) einen Mikrostripe-Aufbau. Die PIN-Dioden werden durch Epitaxie auf das Substrat aufgebracht und sind so zur Masse geschaltet. Jede Ebene ist mit BCB-Isolationsschichten planarisiert.

## Patentansprüche

1. Verfahren zur Herstellung eines integrierten Limiters mit PIN-Dioden,
wobei
- auf einem hochleitenden n⁺-Substrat (1) eine Schichtenfolge einer Diodenstruktur (2) abgeschieden wird,
- zumindest eine Diode mittels einer Mesastruktur, die bis ins n⁺-Substrat (1) reicht, strukturiert wird,
- die Diode elektrisch angeschlossen und die Oberfläche mit einer ersten Planarisierung (9') abgedeckt wird,
- auf der ersten Planariserung (9') zumindest ein ohmscher Widerstand (11) strukturiert wird,
- eine erste BCB-Isolationsschicht (14) abgeschieden wird, durch die Diode und Widerstand mittels Leiterbahnen verschaltet werden,
- eine zweite Planarisierung (16) mit einer zweiten BCB-Isolationsschicht strukturiert wird,
- auf der zweiten Planarisierung zumindest ein Kondensator (17, 18, 19) gebildet wird, der mittels Leiterbahnen (17) mit Diode und Widerstand über Kontaktlöcher verschaltet wird,
- eine dritte Planarisierung (20) mit einer dritten BCB-Isolationsschicht strukturiert wird,
- durch Kontaktlöcher in der dritten Planarisierung (20) die Struktur mittels Leiterbahnen (21) verschaltet und durch eine Anschlußmetallisierung (22) kontaktiert wird.

2. Verfahren nach Anspruch 1, **dadurch gekennzeichnet, daß** auf der Mesastruktur zusätzlich eine erste Oxidschicht (3) strukturiert wird und eine hochleitende n⁺⁺-Kontaktimplantation im n⁺-Substrat (1) erzeugt wird.

3. Verfahren nach Anspruch 1 oder 2, **dadurch gekennzeichnet, daß** an der Mesastruktur eine Seitenwandpassivierung (41, 42) aus siliziumreichen Siliziumoxid oder Siliziumnitrid gebildet wird.

4. Verfahren nach einem der Ansprüche 1 bis 3, **dadurch gekennzeichnet, daß** auf der p-Siliziumschicht (22') der Mesa und der Substratoberfläche (1, 5) eine Salizidschicht (6) gebildet wird.

5. Verfahren nach einem der Ansprüche 1 bis 4, **dadurch gekennzeichnet, daß** die Diodenstruktur (21', 22') in einer geöffneten zweiten Oxidschicht (7) mittels einer ersten Metallisierung (8) elektrisch angeschlossen wird.

6. Verfahren nach einem der Ansprüche 1 bis 5, **dadurch gekennzeichnet, daß** die erste Planarisierung (9') mittels einer dritten Oxidschicht (9) und einer Polyimidschicht (10) gebildet wird.

7. Verfahren nach einem der Ansprüche 1 bis 6, **dadurch gekennzeichnet, daß** der ohmsche Widerstand mittels einer mit einer vierten Oxidschicht (12) abgedeckten Widerstandsschicht (11) und mit einer dritten Metallisierung (13) zur elektrischen Kontaktierung gebildet wird.

8. Integrierter Limiter, bei welchem
- auf einem hochleitenden n⁺-Substrat (1) in einer ersten Ebene zumindest eine PIN-Diode in Mesa-Struktur vorliegt,
- die erste Ebene durch eine erste Planarisierung abgedeckt ist, auf welcher in einer zweiten Ebene zumindest ein ohmscher Widerstand (11) angeordnet ist
- auf die erste Planarisierung eine erste BCB-Isolationsschicht (14) folgt,
- auf einer zweiten Planarisierung mit einer zweiten BCB-Isolationsschicht (16) in einer dritten Ebene wenigstens ein Kondensator (18,19) angeordnet ist
- auf die zweite Planarisierung eine dritte Planarisierung mit einer dritten BCB-Isolationsschicht (20) folgt
- über der dritten BCB-Isolationsschicht (20) eine Anschlußmetallisierung (21) vorliegt
- die Bauelemente der verschiedenen Ebenen durch Leiterbahnen und Kontaktlöcher (15,17) untereinander zu dem Limiter verschaltet sind.

9. Integrierter Limiter nach Anspruch 8, **dadurch gekennzeichnet, daß** an einer Mesastruktur der PIN-Diode eine Seitenwandpassivierung (41, 42) aus siliziumreichen Siliziumoxid oder Siliziumnitrid angebracht ist.

10. Integrierter Limiter nach Anspruch 8 oder 9, **dadurch gekennzeichnet, daß** jede Ebene mittels BCB-Isolationsschichten planarisiert sind.

## Claims

1. Method for producing an integrated limiter with PIN diodes, wherein
- a layer sequence of a diode structure (2) is deposited on a highly conductive n⁺-type substrate (1) ,
- at least one diode is structured by means of a mesa structure reaching right into the n⁺-type substrate (1),
- the diode is electrically connected and the surface is covered with a first planarization (9'),
- at least one non-reactive resistor (11) is structured on the first planarization (9'),
- a first BCB insulation layer (14) is deposited, through which diode and resistor are connected up by means of interconnects,
- a second planarization (16) is structured with a second BCB insulation layer,
- at least one capacitor (17, 18, 19) is formed on the second planarization, said at least one capacitor being connected up by means of interconnects (17) to diode and resistor via contact holes,
- a third planarization (20) is structured with a third BCB insulation layer,
- through contact holes in the third planarization (20), the structure is connected up by means of interconnects (21) and contact-connected by a connection metallization (22).

2. Method according to Claim 1, **characterized in that**, in addition, a first oxide layer (3) is structured on the mesa structure and a highly conductive n⁺⁺-type contact implantation is produced in the n⁺-type substrate (1).

3. Method according to Claim 1 or 2, **characterized in that** a sidewall passivation (41, 42) composed of silicon-rich silicon oxide or silicon nitride is formed on the mesa structure.

4. Method according to any of Claims 1 to 3, **characterized in that** a salicide layer (6) is formed on the p-type silicon layer (22') of the mesa and the substrate surface (1, 5).

5. Method according to any of Claims 1 to 4, **characterized in that** the diode structure (21', 22') is electrically connected by means of a first metallization (8) in an opened second oxide layer (7).

6. Method according to any of Claims 1 to 5, **characterized in that** the first planarization (9') is formed by means of a third oxide layer (9) and a polyimide layer (10).

7. Method according to any of Claims 1 to 6, **characterized in that** the non-reactive resistor is formed by means of a resistive layer (11) covered with a fourth oxide layer (12), and with a third metallization (13) for electrical contact-connection.

8. Integrated limiter wherein
- at least one PIN diode in mesa structure is present in a first plane on a highly conductive n⁺-type substrate (1),
- the first plane is covered by a first planarization, on which at least one non-reactive resistor (11) is arranged in a second plane,
- the first planarization is followed by a first BCB insulation layer (14),
- at least one capacitor (18, 19) is arranged on a second planarization with a second BCB insulation layer (16) in a third plane,
- the second planarization is followed by a third planarization with a third BCB insulation layer (20),
- a connection metallization (21) is present above the third BCB insulation layer (20),
- the components of the different planes are interconnected to form the limiter by means of interconnects and contact holes (15, 17).

9. Integrated limiter according to Claim 8, **characterized in that** a sidewall passivation (41, 42) composed of silicon-rich silicon oxide or silicon nitride is fitted to a mesa structure of PIN diode.

10. Integrated limiter according to Claim 8 or 9, **characterized in that** each plane is planarized by means of BCB insulation layers.

## Revendications

1. Procédé de fabrication d'un limiteur intégré à diodes PIN, dans lequel
- une succession de couches d'une structure (2) de diode est déposée sur un substrat n⁺ (1) hautement conducteur,
- au moins une diode est structurée au moyen d'une structure en mésa qui s'étend jusqu'à l'intérieur du substrat n⁺ (1),
- la diode est raccordée électriquement et sa surface est couverte d'une première couche de planage (9'),
- au moins une résistance ohmique (11) est structurée sur la première couche de planage (9'),
- une première couche isolante BCB (14) par laquelle la diode et la résistance sont raccordées au moyen de pistes conductrices est déposée,
- une deuxième couche de planage (16) dotée d'une deuxième couche isolante BCB est structurée,
- au moins un condensateur (17, 18, 19) qui est raccordé à la diode et à la résistance au moyen de pistes conductrices (17) qui traversent des trous de contact est formé sur la deuxième couche de planage,
- une troisième couche de planage (20) dotée d'une troisième couche isolante BCB est structurée,
- la structure est raccordée au moyen de pistes conductrices (21) qui traversent les trous de contact ménagés dans la troisième couche de planage (20) et est mise en contact avec une métallisation de raccordement (22).

2. Procédé selon la revendication 1, **caractérisé en ce qu'**une première couche d'oxyde (3) est de plus structurée sur la structure en mésa et **en ce qu'**une implantation de contact n⁺⁺ hautement conductrice est formée dans le substrat n⁺ (1).

3. Procédé selon les revendications 1 ou 2, **caractérisé en ce qu'**une passivation (41, 42) des parois latérales en oxyde de silicium riche en silicium ou en nitrure de silicium est formée sur la structure en mésa.

4. Procédé selon l'une des revendications 1 à 3, **caractérisé en ce qu'**une couche de siliciure (6) est formée sur la couche (22') de silicium p de la mésa et de la surface (1, 5) du substrat.

5. Procédé selon l'une des revendications 1 à 4, **caractérisé en ce que** la structure de diode (21', 22') disposée dans une deuxième couche d'oxyde (7) ouverte est raccordée électriquement au moyen d'une première métallisation (8).

6. Procédé selon l'une des revendications 1 à 5, **caractérisé en ce que** la première couche de planage (9') est formée au moyen d'une troisième couche d'oxyde (9) et d'une couche (10) de polyimide.

7. Procédé selon l'une des revendications 1 à 6, **caractérisé en ce que** la résistance ohmique est formée au moyen d'une couche de résistance (11) recouverte d'une quatrième couche d'oxyde (12) et d'une troisième métallisation (13) qui assure le contact électrique.

8. Limiteur intégré, dans lequel
- au moins une diode PIN à structure en mésa est prévue dans un premier plan sur un substrat n⁺ (1) hautement conducteur,
- le premier plan est recouvert par une première couche de planage sur laquelle une résistance ohmique (11) est disposée dans un deuxième plan,
- une première couche isolante BCB (14) suit la première couche de planage,
- au moins un condensateur (18, 19) est disposé avec une deuxième couche d'isolation BCB (16) dans un troisième plan sur une deuxième couche de planage,
- une troisième couche de planage qui présente une troisième couche d'isolation BCB (20) suit sur la deuxième couche de planage,
- une métallisation de raccordement (21) est prévue au-dessus de la troisième couche d'isolation BCB (20) et
- les composants des différents plans sont raccordés les uns avec les autres par des pistes conductrices et des trous de contact (15, 17) pour former le limiteur.

9. Limiteur intégré selon la revendication 8, **caractérisé en ce qu'**une passivation (41, 42) des parois latérales constituées d'oxyde de silicium riche en silicium et de nitrure de silicium est appliquée sur une structure en mésa de la diode PIN.

10. Limiteur intégré selon les revendications 8 ou 9, **caractérisé en ce que** chaque plan est plané au moyen de couches d'isolation BCB.
